# EUROPEAN PATENT SPECIFICATION

(11) **EP 0 481 752 B1**
(45) Date of publication and mention of the grant of the patent: **14.01.1998**
(21) Application number: 91309522.0
(22) Date of filing: 16.10.1991
(51) Int. Cl.: H03M 13/00

(54) **Error correction code encoder and decoder**
Fehlerkorrekturkoder und Dekoder
Codeur et décodeur de codes à correction d'erreurs

(30) Priority: 17.10.1990 JP 279714/90
(43) Date of publication of application: 22.04.1992
(73) Proprietor: CANON KABUSHIKI KAISHA, Tokyo (JP)
(72) Inventor: Shimizu, Tetsuya, c/o Canon Kabushiki Kaisha, Ohta-ku, Tokyo (JP)
(74) Representative: Beresford, Keith Denis Lewis

(56) References cited:
- EP-A- 0 042 121
- EP-A- 0 191 410
- EP-A- 0 341 851
- GB-A- 2 065 416

## Description

The present invention relates to an error correction code encoder and decoder, and more particulayly to an encoder and decoder using a so-called product code as an error correction code in a system which transmits a code train via a transmission path such as a magnetic recording/reproducing path which may sometimes generate burst errors.

It is known that a so-called interleave method is used to improve an error correction capability of a system having a transmission path such as a magnetic recording/reproducing path which may sometimes generate burst errors. With this interleave method, data after being subject to error correction code encoding and constituting the same encoded block or same error correction code, is distributedly sent to a transmission line.

Such an interleave method used by a video VTR will be described by way of example.

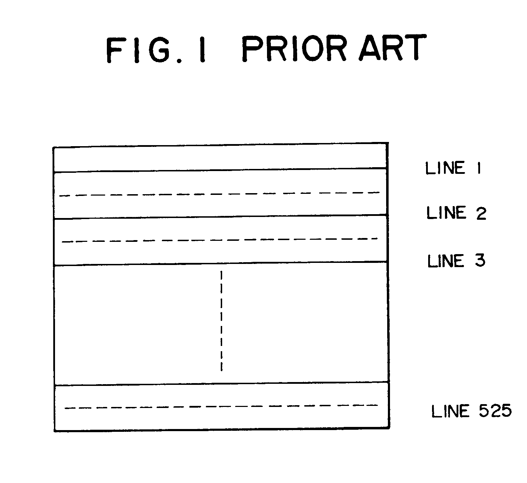

Fig. 1 is a diagram used for explaining a video signal processed by a digital VTR. In Fig. 1, there are shown horizontal scan lines including the first, second, ..., 525-th line. In this example, a video signal having 525 horizontal scan lines such as an NTSC signal is used.

In VTR, digital video signals of one frame are divided into a predetermined number (P) of blocks. Each block is subject to error correction code encoding, and written in one track. Namely, P tracks are used for recording video signals of one frame.

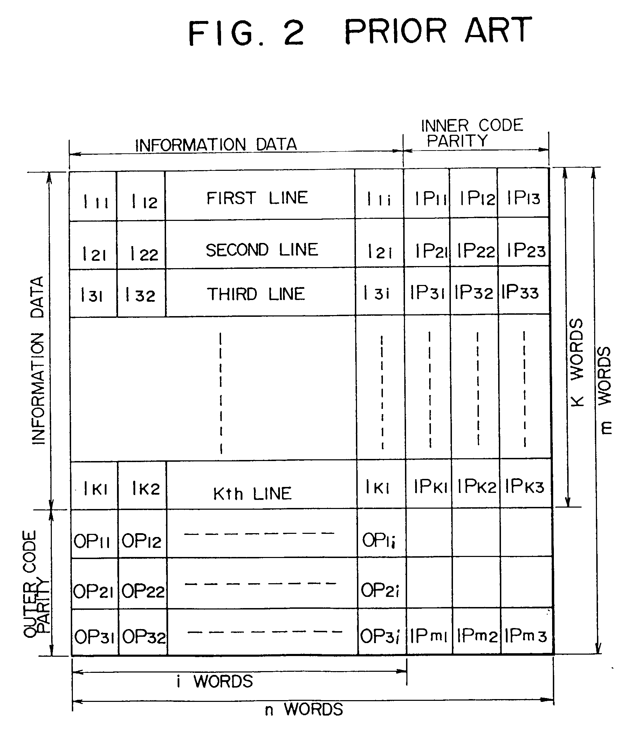

Fig. 2 is a diagram illustrating error correction code encoded blocks. As shown in Fig. 2, information data (information words) I₁₁ to Iₖᵢ is encoded by using such as Reed Solomon codes to provide inner codes in the horizontal direction and outer codes in the vertical direction, i.e., provide so-called product codes. In this example, it is assumed that inner and outer codes include three parity words (check bits) IP₁₁ to ₃ₘ, and OP₁₁ to OP₃ₖ, respectively, and that each code can correct one word error.

The order of recording data (order of data transmission) in a magnetic tape is the same as the direction of inner code encoding, i.e., in the order of I₁₁, I₁₂, I₁₃, ..., Iₗᵢ, IP₁₁, IP₁₂, IP₁₃, I₂₁, I₂₂, .... Therefore, burst errors caused by dropout by scratches or stains of a magnetic tape during a reproducing operation are consecutive in the inner code encoding direction.

As described above, if each outer or inner code can correct one word, burst errors of maximum one line or i words can be corrected by outer codes, but burst errors more than this cannot be corrected.

In order to improve the error correction capability, data is encoded for each block. The encoded data is exchanged between blocks to record mixed data of a plurality of blocks in one track. For example, in a simple case, data of two blocks is exchanged on the line unit basis. With such an arrangement, even if burst errors more than one line occur, burst errors of maximum two lines can be corrected using outer codes because the reproducing process can be performed one line per each block. However, in this case, two tracks for the unit interleave process should not contain other burst errors or random errors. It can be said therefore that the above-described interleave method is very effective for improving the error correction capability without having a large redundancy if occurrence frequency of burst errors is low to a certain degree.

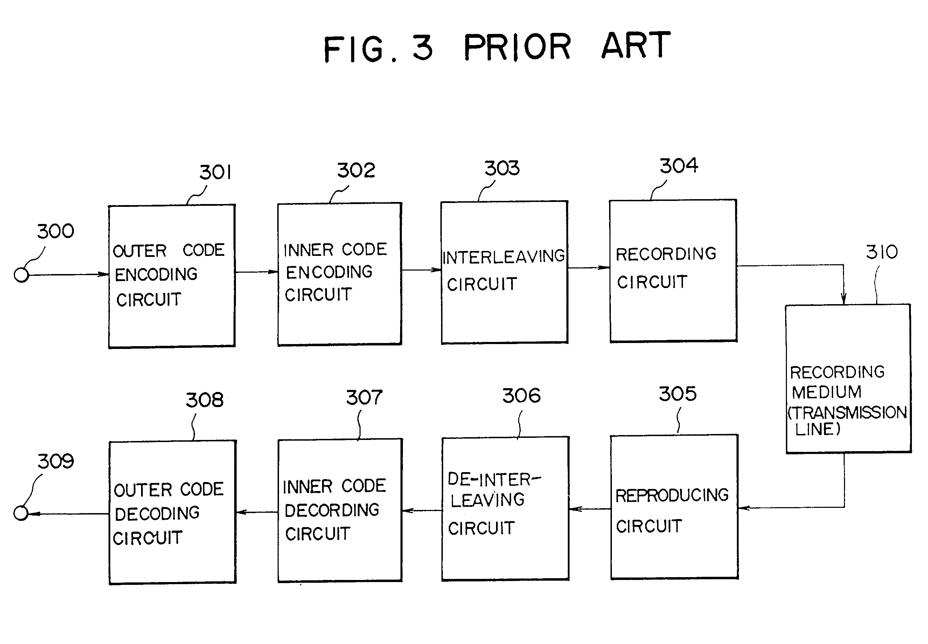

Fig. 3 is a block diagram showing the brief arrangement of a conventional digital VTR which uses the interleave method.

Information data inputted from an input terminal 300 is encoded on the block unit basis by an outer code encoding circuit 301 and inner code encoding circuit 302. The data is exchanged or interleaved in line unit or word unit at an interleave circuit 303 by using a memory. The interleave circuit 303 sequentially outputs data of a plurality of blocks to a recording circuit 304 which processes the data for magnetically recording it in a magnetic tape (recording medium) 310 serving as a transmission path.

A signal picked up from the magnetic tape 310 is supplied to a reproducing circuit 305 to reproduce data. The reproduced data is processed by a de-inter-leave circuit 306 in the manner opposite to the interleave circuit 303, and sequentially outputted one line after another in units of block such as shown in Fig. 2. The outputted data is subject to error correction processes at an inner code decoding circuit 307 and outer code decoding circuit 308 using inner and outer codes. The error-corrected digital video signal is outputted from an output terminal 309.

The above-described digital VTR requires address generators, memories, and the like, which are used for the interleave process only, resulting in an increase of hardware.

Furthermore, the order of data before encoding is different from the order of data on a magnetic tape (on a transmission line). Therefore, a desired data order before error correction code encoding cannot be recorded (transmitted) as it is. In a special reproducing mode of a digital VTR, such as a high speed search which reproduces data while transporting a tape at a speed different from that when recording it, a particular data order is used for allowing effective pixel reproduction. This particular data order of video signals changes if error correction code encoding is performed. It becomes therefore necessary to rearrange the data after error correction code encoding, or to determine a data order while considering such change in advance. In the former case, complicated processing is required, and moreover this processing is carried out with parity bits (words) being affixed so that data amount to be process becomes bulky and the amount of hardware increases. Also in the latter case, complicated processing is required, a time required for data exchange may become longer, and the amount of hardware increases.

GB-A-2065416 discloses a device for encoding information codes with error correction codes, the device comprising input means for inputting an information code sequence; first encoding means for generating a plurality of first encoded words each of which is composed of first parity codes and a predetermined number of consecutive information codes of said information code sequence; and second encoding means for generating a plurality of second encoded words, each of which is composed of second parity codes and an information code of each of a predetermined number of the first encoded words. In this arrangement the second encoded words are formed from each of the first encoded words.

EP-A-0341851 discloses a method for interleaving encoded data symbols into code words of a Reed-Solomon error correction code using a generator polynomial. A multiple of L registers are used to virtually interleave the symbols.

It is an object of the present invention to provide an error correction code encoder and decoder having a high error correction capability without increasing hardware so much.

According to one aspect the present invention provides a device for encoding information data with error correction codes, the device comprising:
input means for inputting an information data sequence;
first encoding means for generating a plurality of first code words each of which is composed of first parity codes and a predetermined number of consecutive information data of said information data sequence; and
second encoding means for generating a plurality of second code words, each of which is composed of second parity codes and information data of each of a predetermined number of the first code words;
characterised in that
said second encoding means is adapted to generate the second code words such that said predetermined number of the first code words is every N^{th} first code word, where N is an integer of 2 or more.

According to another aspect the present invention provides a method of encoding information data with error correction codes, the method comprising steps of:
inputting an information data sequence having consecutive information data,
generating a plurality of first code words each of which is composed of first parity codes and a predetermined number of the information data consecutively input, and
generating a plurality of second code words each of which is composed of second parity codes and information data of each of a predetermined number of the first code words;
characterised in that
the predetermined number of the first code words is every N^{th} first code word; where N is an integer of 2 or more.

According to a further aspect the present invention provides a device for decoding error correction codes, the device comprising:
input means for inputting information data encoded with error correction codes comprising first and second parity codes;
first decoding means for decoding a plurality of first code words each of which is composed of first parity codes and a predetermined number of consecutive information data;
second decoding means for decoding a plurality of second code words, each of which is composed of second parity codes and information data of each of a predetermined number of the first code words;
characterised in that
said second decoding means is adapted to decode each of the second code words to error correct the information data of every N^{th} first code word, where N is an integer of 2 or more.

According to still a further aspect of the present invention provides a method of decoding error correction codes, the method comprising the steps of:
inputting information data encoded with error correction codes comprising first and second parity codes;
decoding a plurality of first code words each of which is composed of first parity codes and a predetermined number of consecutive information data; and
decoding a plurality of second code words each of which is composed of second parity codes and information data of each of a predetermined number of the first code words;
characterised in that
the predetermined number of the first code words is every N^{th} first code word, where N is an integer of 2 or more.

Embodiments of the present invention will now be described with reference to the accompanying drawings in which:
Fig. 1 is a diagram used for explaining a video signal used in a digital VTR;
Fig. 2 is a diagram showing error correction code encoded blocks of a conventional digital VTR;
Fig. 3 is a block diagram showing the brief arrangement of a conventional digital VTR;
Fig. 4 is a schematic diagram showing the main part of a recording system of a VTR according to an embodiment of the present invention;
Fig. 5 is a diagram showing the structure of error correction code encoded blocks used for explaining an error correction code encoding method used by VTR shown in Fig. 4;
Fig. 6 is a diagram showing a recording state of a tape used by VTR shown in Fig. 4; and
Fig. 7 is a schematic diagram showing the main part of a reproducing system for VTR shown in Fig. 4.

An embodiment of the present invention applied to a digital VTR will be described.

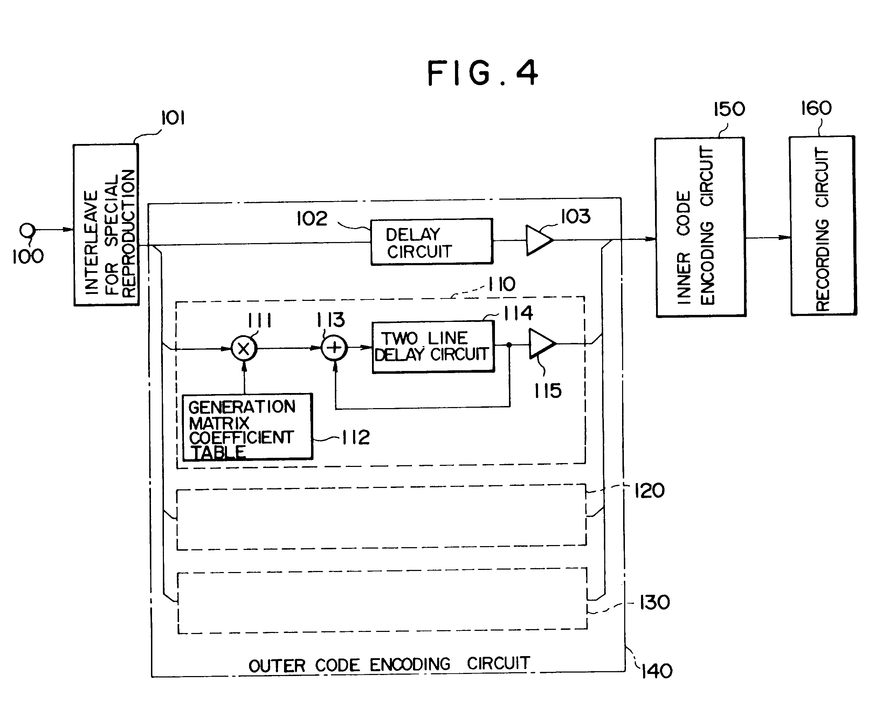

Fig. 4 is a schematic diagram briefly showing the main part of a recording system of a digital VTR according to an embodiment of the present invention.

In Fig. 4, reference numeral 100 represents an input terminal for a digital video signal. Like an ordinary television signal, data of each frame, each field, and each line is time sequentially inputted. Reference numeral 101 represents a special reproduction interleave circuit which changes a time sequential inputted digital video signal into a form suitable for a special reproduction such as high speed search. The structure of such a special reproduction interleave circuit can be realized using the teachings given in JP-A-1228382 filed on March 1, 1989. The structure of the circuit is not directly related to the present invention, so the detailed description thereof is omitted. It is assumed in this embodiment that the interleave circuit 101 interleaves data on the line unit basis.

Reference numeral 140 represents an outer code encoding circuit which receives a data train from the special reproduction interleave circuit 101. The data train with outer code parities added by the outer code encoding circuit 140 is inputted to an inner code encoding circuit 150 which further adds inner code parities.

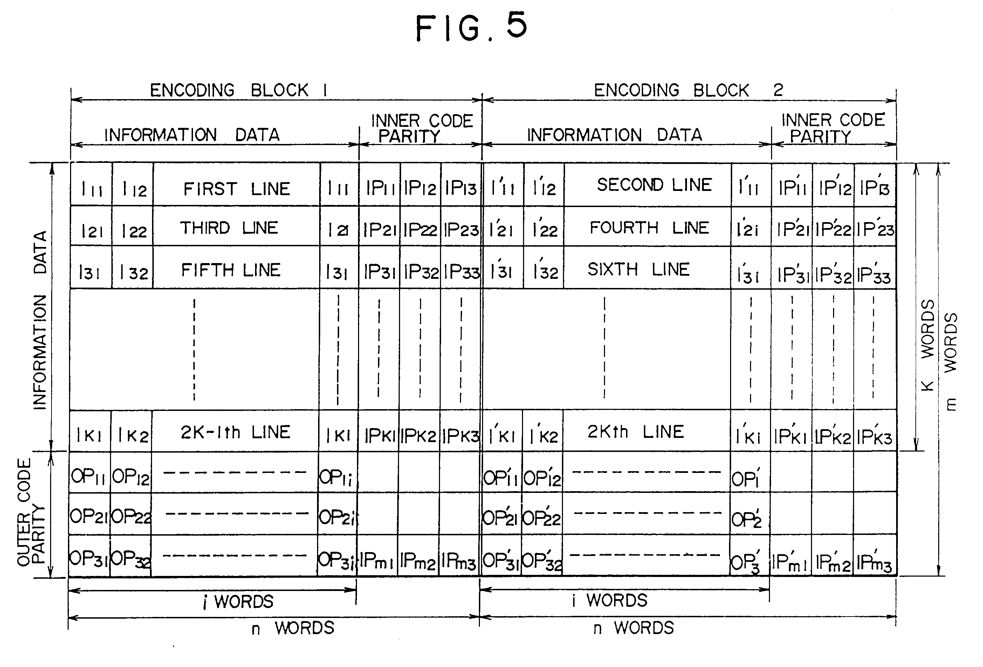

Fig. 5 is a diagram showing encoded blocks used for explaining the error correction code encoding method used by VTR of this embodiment. Data on the first to 2k-th lines are sequentially inputted to the outer code encoding circuit 140 in this order. As shown in Fig. 5, it is assumed that three parity words are added as outer codes and as inner codes, respectively, and that each parity word can correct one word at the maximum.

Referring to Fig. 4, the data from the special reproduction interleave circuit 101 is inputted in parallel to a delay circuit 102, P0 parity calculation circuit 110, P1 parity calculation circuit 120, and P2 parity calculation circuit 130.

The structures of the parity calculation circuits 110, 120, and 130 are the same except that coefficients of generation matrix coefficient tables 112 are different. The three parity calculation circuits calculate three parity words.

The operation of the parity calculation circuit will be described using the P0 parity calculation circuit 110 as an example. The information data supplied to the circuit 110 is inputted to a multiplier 111 on a Galois field. The generation matrix coefficient table 112 is constructed of a ROM and an address controller to sequentially output a coefficient of the generation matrix. The multiplier 111 multiplies the information data (word) by a coefficient outputted from the table 112, on a Galois field. An output of the multiplier 111 is supplied to an adder 113 constructed of an exclusive OR gate, and added to an addition result before two lines supplied from a two-line delay circuit 114. The adder 113 and two-line delay circuit 114 constitute an accumulator which accumulates the multiplication results between information words and coefficients at every second lines.

The above-described processes are executed for all information words I₁₁ to Iₖᵢ and I'₁₁ to I'ₖᵢ i.e., information words for 2k lines. Thus, outer codes different between odd lines and even lines are generated as shown in Fig. 5. outer code parity words P0 (OP₁₁ to OP₁ₖ shown in Fig. 5) are generated for odd line information codes, and outer code parity words P0 (OP'₁₁ to OP'₁ₖ shown in Fig. 5) are generated for even line information codes. The generated parity words are stored in the delay circuit 114. Reference numeral 115 represents a buffer.

Similarly, the two-line delay circuits of the P1 and P2 parity calculation circuits 120 and 130 store therein outer code parity words P1 and P2 (OP₂₁ to OP₂ₖ, OP₃₁ to OP₃ₖ in Fig. 5) for odd line information codes and outer code parity words P1 and P2 (OP'₂₁ to OP'₂ₖ, OP'₃₁ to OP'₃₁ in Fig. 5) for even line information codes.

The delay circuit 102 provides the information data with a delay time corresponding to the time required for processing one word by the parity calculation circuit 110, 120, 130, and outputs the information data for the first to 2k-th lines in the order of having been inputted. The portion where inner code parity words are inserted is made undefined.

After the information data (2k x i words) of the two sets of blocks shown in Fig. 5 has been outputted, the parity words stored in the two-line delay circuits of the parity calculation circuits 110, 120, and 130 are sequentially outputted via the buffers in the order of P0, P1, and P2 so that outer code parity words for six lines are outputted and added to respective 2k-lines information codes.

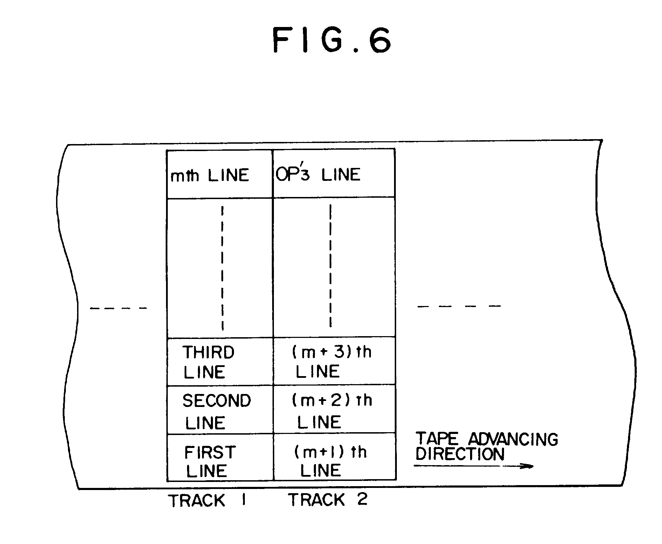

An output of the outer code encoding circuit 140 is supplied to an inner code encoding circuit 150 and added with inner code parity words for each line, the inner code parity words being calculated in the well known manner. The information words for 2k lines, 6k outer code parity words, and 6m inner code parity words are supplied to a recording circuit 160 sequentially for each line of the two sets of blocks shown in Fig. 5. These words are distributedly written on two tracks of a magnetic tape as shown in Fig. 6.

With the error correction code encoding described above, even if burst errors of maximum two lines are present, each one word error can be corrected by using a corresponding one of outer codes. This improvement on error correction capability is the same as the conventional case wherein the dedicated interleave circuit 303 is additionally provided. The order of information codes is not-changed at all throughout the circuit path from the input stage of the outer code encoding circuit 140 to the input stage of the recording circuit 160, without influencing the order of information codes (video data) given by the specific reproduction interleave circuit 101. Thus, it is not necessary to rearrange the order of k information codes after the error correction code encoding, making small the hardware amount of the specific reproduction interleave circuit 101. Various interleave rules can be considered for the specific reproduction interleave circuit 101. In general, data is distributed in units of line to a plurality of tracks constituting one frame, and the data of one frame is thinned in units of line and uniformly distributed to each track.

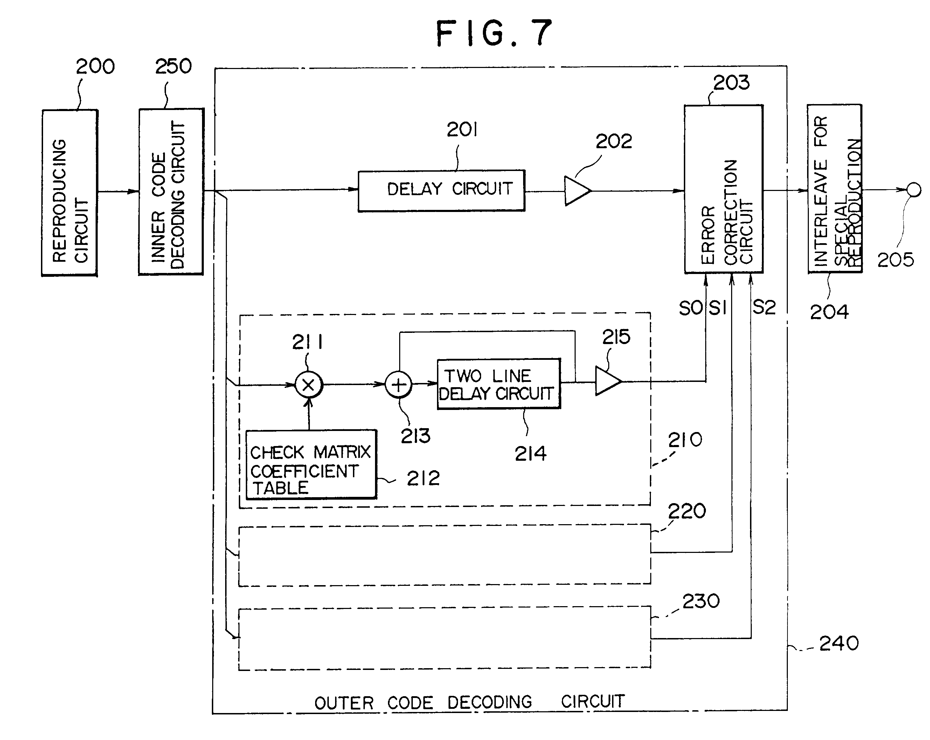

Fig. 7 briefly shows an example of the arrangement of the main part of a reproducing recording system for code trains encoded as described above. Reference numeral 200 represents a reproducing circuit which reproduces code trains recorded on a magnetic tape shown in Fig. 6.

The reproduced code train is supplied to an inner code decoding circuit 250 which calculates a syndrome of one line information words and three parity words so that an error is corrected by inner codes. Then, the code trains, i.e., information words with errors corrected by inner codes and outer code parity words, are supplied in parallel to a delay circuit 201, S0 syndrome calculation circuit 210, S1 syndrome calculation circuit 220, and S2 syndrome calculation circuit 230, one line after another.

The structures of the syndrome calculation circuits 210, 220, and 230 are the same except that coefficients of check matrix coefficient tables 212 are different. The three syndrome calculation circuits calculate three syndromes S0, S1, and S2.

The operation of the syndrome calculation circuit will be described using the S0 syndrome calculation circuit 210 as an example.

The information data supplied to the syndrome calculation circuit 210 is inputted to a multiplier 211 on a Galois field. The check matrix coefficient table 212 is constructed of a ROM and an address controller to sequentially output a coefficient of the check matrix. The multiplier 211 multiplies the inputted word by a coefficient outputted from the table 212, on a Galois field. An output of the multiplier 211 is supplied to an adder 213 constructed of an exclusive OR gate, and added to an addition result before two lines supplied from a two-line delay circuit 214. The adder 213 and two-line delay circuit 214 constitute an accumulator which accumulates the multiplication results between information words, parity words and coefficients at every second lines.

The above-described processes are executed for all information words I₁₁ to Iₖᵢ and I'₁₁ to I'ₖᵢ and parity words OP₁₁ to OP'₃ₖ , OP₁₁ to OP'₃ₖ, for two lines. Thus, different syndromes S0 are calculated for odd lines and even lines.

The above-described processes are carried out by the syndrome calculation circuits 210, 220, and 230, so that syndromes S0, S1, and S2 for all outer codes are calculated, which are stored in two-line delay circuits within the circuits 210, 220, and 230.

An error correction circuit 203 corrects errors of the information data supplied from the delay circuit 201 via a buffer 202, by using syndromes S0, S1, and S2 supplied from the syndrome calculation circuits 210, 220, and 230 via buffers 215, in the well known manner. If each outer code can correct one word, consecutive errors within two lines (2n words) generated by the reproducing circuit 200 can be corrected by the outer code decoding circuit 240.

The first to 2k-th line information words are outputted from the outer code decoding circuit 240 in the order of having been reproduced, in the manner same as conventional. The order of the outputted information words is rearranged to recover the original order by a specific reproduction de-interleave circuit 204 which executes an rearrangement opposite to that of the specific reproduction interleave circuit 101, and outputted from an output terminal 205.

A VTR having an encoder and decoder described above can improve the burst error correction capability of outer codes by using a different capacity of delay circuits within the encoder and decoder. Error correction is performed within the processes of the encoder and decoder using error correction codes including outer and inner codes. Therefore, the hardware amounts of both the recording system (encoding system) and reproducing system (decoding system) will not become large while dispensing with a dedicated interleave circuit. Furthermore, such processes will not change the order of information code trains, without influencing a specific reproduction interleave.

In the above embodiment, inner codes are disposed in the direction same as the direction of occurrence of burst errors. Namely, inner codes are added to consecutive information codes of i words (one line), and outer codes are obtained basing upon words derived at every second lines in the direction different from the first-mentioned direction. Instead, outer codes may be obtained basing upon words at each line, and inner codes may be obtained basing upon words derived at every second lines, with the similar advantageous effects being ensured. In other words, first and second error correction codes may be inner and outer codes, or vice versa.

In the above embodiment, outer codes (second error correction codes) are obtained basing upon information words derived at every second lines, i.e., information words derived in the vertical direction of the data matrix shown in Fig. 5. Outer codes may be obtained basing upon information words derived in the oblique direction of the matrix, i.e., second codes (outer codes) may be obtained basing upon information words each derived from 2i consecutively transmitted information words, with the similar advantageous effects being ensured.

Furthermore, in the above embodiment, as shown in Fig. 6, 3k outer code parity words are written concentrated on a magnetic tape at every second tracks. It is possible to distributedly allocate outer code parity words by increasing the capacity of the delay circuits 102 and 201 shown in Figs. 4 and 7. In this case, in addition to the above-described advantageous effects, errors at the reproducing circuit 200 can be reduced by decreasing the d.c. components of a code train.

As described so far, according to the present invention, it is possible to realize an error correction code encoder and decoder having a high burst error correction capability without increasing the hardware amount to much extent.

## Claims

1. A device for encoding information data with error correction codes, the device comprising:
input means (100) for inputting an information data sequence;
first encoding means (150) for generating a plurality of first code words each of which is composed of first parity codes and a predetermined number of consecutive information data of said information data sequence; and
second encoding means (140) for generating a plurality of second code words, each of which is composed of second parity codes and information data of each of a predetermined number of the first code words;
characterised in that
said second encoding means (140) is adapted to generate the second code words such that said predetermined number of the first code words is every N^{th} first code word, where N is an integer of 2 or more.

2. A device according to claim 1, further comprising transmission means for transmitting said information data sequence added with said first and second parity codes to a transmission path, without changing the order of information data of said information data sequence.

3. A device according to claim 1 or claim 2, wherein said information data are video data, and the predetermined number of information data of each of the first code words corresponds to video information of one horizontal scan line.

4. A device according to any preceding claim, wherein said first parity codes are inner code words, and said second parity codes are outer code words.

5. A device according to any preceding claim, wherein said second encoding means (140) includes a multiplier (111) for multiplication of the information data of the second code words, and an accumulator (113,114) which accumulates outputs of the multiplier (111) and includes a delay circuit (114) having a delay time longer than a period corresponding to N of the first code words and an adder (113).

6. A method of encoding information data with error correction codes, the method comprising steps of:
inputting an information data sequence having consecutive information data,
generating a plurality of first code words each of which is composed of first parity codes and a predetermined number of the information data consecutively input, and
generating a plurality of second code words each of which is composed of second parity codes and information data of each of a predetermined number of the first code words;
characterised in that
the predetermined number of the first code words is every N^{th} first code word; where N is an integer of 2 or more.

7. A method according to claim 6 wherein said information data are video data, and the predetermined number of information data of each of the first code words corresponds to video information of one horizontal scan line.

8. A method according to claim 6 or claim 7 wherein said first parity codes are inner code words, and said second parity codes are outer code words.

9. A device for decoding error correction codes, the device comprising:
input means (200) for inputting information data encoded with error correction codes comprising first and second parity codes;
first decoding means (250) for decoding a plurality of first code words each of which is composed of first parity codes and a predetermined number of consecutive information data;
second decoding means (240) for decoding a plurality of second code words, each of which is composed of second parity codes and information data of each of a predetermined number of the first code words;
characterised in that
said second decoding means (240) is adapted to decode each of the second code words to error correct the information data of every N^{th} first code word, where N is an integer of 2 or more.

10. A device according to claim 9, further comprising reception means for receiving said information data added with said first and second parity codes from a transmission line, and supplying said information data to said first and second decoding means (240,250) without changing the order of said information data.

11. A device according to claim 9 or claim 10, wherein said information data are video data, and the information data of each of the first code words corresponds to video information of one horizontal scan line.

12. A device according to any one of claims 9 to 11, wherein said first parity codes are inner code words, and said second parity codes are outer code words.

13. A device according to any one of claims 9 to 12, wherein said second decoding means (240) includes a multiplier (211) for multiplication of said information data and said second parity codes constituting said second code word by a check matrix (212), and an accumulator (213,214) which accumulates the output of the multiplier (211) and includes a delay circuit (214) having a delay time longer than a period corresponding to N of the first code words and an adder (213), and said second decoding means (240) corrects an error using a syndrome outputted from said accumulator (213,214).

14. A method of decoding error correction codes, the method comprising the steps of:
inputting information data encoded with error correction codes comprising first and second parity codes;
decoding a plurality of first code words each of which is composed of first parity codes and a predetermined number of consecutive information data; and
decoding a plurality of second code words each of which is composed of second parity codes and information data of each of a predetermined number of the first code words;
characterised in that
the predetermined number of the first code words is every N^{th} first code word, where N is an integer of 2 or more.

15. A method as claimed in claim 14 wherein said information data are video data, and the information data of each of the first code words corresponds to video information of one horizontal scan line.

16. A method as claimed in claim 14 or 15 wherein said first parity codes are inner code words, and said second parity codes are outer code words.

## Patentansprüche

1. Vorrichtung zur Kodierung von Informationsdaten mit Fehlerkorrekturcodes mit
einer Eingabeeinrichtung (100) zur Eingabe einer Informationsdatenfolge,
einer ersten Kodiereinrichtung (150) zur Erzeugung einer Vielzahl von ersten Codeworten, die jeweils aus ersten Paritätscodes und einer vorbestimmten Anzahl von aufeinanderfolgenden Informationsdaten der Informationsdatenfolge bestehen, und
einer zweiten Kodiereinrichtung (140) zur Erzeugung einer Vielzahl von zweiten Codeworten, die jeweils aus zweiten Paritätscodes und Informationsdaten jedes ersten Codeworts einer vorbestimmten Anzahl der ersten Codeworte bestehen,
**dadurch gekennzeichnet, daß**
die zweite Kodiereinrichtung (140) die zweiten Codeworte derart erzeugt, daß die vorbestimmte Anzahl der ersten Codeworte jedes N-te erste Codewort ist, wobei N eine ganze Zahl größer oder gleich 2 ist.

2. Vorrichtung nach Anspruch 1, **gekennzeichnet durch**
eine Übertragungseinrichtung zur Übertragung der Informationsdatenfolge, zu der die ersten und zweiten Paritätscodes hinzugefügt sind, zu einem Übertragungsweg ohne Veränderung der Reihenfolge von Informationsdaten der Informationsdatenfolge.

3. Vorrichtung nach Anspruch 1 oder 2, **dadurch gekennzeichnet, daß**
die Informationsdaten Videodaten sind und die vorbestimmte Anzahl von Informationsdaten jedes ersten Codeworts Videoinformationen einer horizontalen Abtastzeile entspricht.

4. Vorrichtung nach einem der vorhergehenden Ansprüche, **dadurch gekennzeichnet, daß**
die ersten Paritätscodes innere Codeworte und die zweiten Paritätscodes äußere Codeworte sind.

5. Vorrichtung nach einem der vorhergehenden Ansprüche, **dadurch gekennzeichnet, daß**
die zweite Kodiereinrichtung (140) einen Multiplizierer (111) zur Multiplikation der Informationsdaten der zweiten Codeworte und einen Akkumulator (113, 114) enthält, der Ausgangssignale des Multiplizierers (111) akkumuliert und eine Verzögerungsschaltung (114) mit einer Verzögerungszeit, die länger als eine Periode ist, die N der ersten Codeworte entspricht, und einen Addierer (113) enthält.

6. Verfahren zur Kodierung von Informationsdaten mit Fehlerkorrekturcodes mit den Schritten
Eingeben einer Informationsdatenfolge mit aufeinanderfolgenden Informationsdaten,
Erzeugen einer Vielzahl von ersten Codeworten, die jeweils aus ersten Paritätscodes und einer vorbestimmten Anzahl der aufeinanderfolgend eingegebenen Informationsdaten bestehen, und
Erzeugen einer Vielzahl von zweiten Codeworten, die jeweils aus zweiten Paritätscodes und Informationsdaten jedes ersten Codeworts einer vorbestimmten Anzahl der ersten Codeworte bestehen,
**dadurch gekennzeichnet, daß**
die vorbestimmte Anzahl der ersten Codeworte jedes N-te erste Codewort ist, wobei N eine ganze Zahl größer oder gleich 2 ist.

7. Verfahren nach Anspruch 6, **dadurch gekennzeichnet, daß** die Informationsdaten Videodaten sind und die vorbestimmte Anzahl von Informationsdaten jedes ersten Codeworts Videoinformationen einer horizontalen Abtastzeile entspricht.

8. Verfahren nach Anspruch 6 oder 7, **dadurch gekennzeichnet, daß**
die ersten Paritätscodes innere Codeworte und die zweiten Paritätscodes äußere Codeworte sind.

9. Vorrichtung zur Dekodierung von Fehlerkorrekturcodes mit
einer Eingabeeinrichtung (200) zur Eingabe von Informationsdaten, die mit erste und zweite Paritätscodes aufweisenden Fehlerkorrekturcodes kodiert sind,
einer ersten Dekodiereinrichtung (250) zur Dekodierung einer Vielzahl von ersten Codeworten, die jeweils aus ersten Paritätscodes und einer vorbestimmten Anzahl von aufeinanderfolgenden Informationsdaten bestehen,
einer zweiten Dekodiereinrichtung (240) zur Dekodierung einer Vielzahl von zweiten Codeworten, die jeweils aus zweiten Paritätscodes und Informationsdaten jedes ersten Codeworts einer vorbestimmten Anzahl der ersten Codeworte bestehen,
**dadurch gekennzeichnet, daß**
die zweite Dekodiereinrichtung (240) jedes zweite Codewort zur Fehlerkorrektur der Informationsdaten jedes N-ten ersten Codeworts dekodiert, wobei N eine ganze Zahl größer oder gleich 2 ist.

10. Vorrichtung nach Anspruch 9, **gekennzeichnet durch**
eine Empfangseinrichtung zum Empfang der Informationsdaten, zu denen die ersten und zweiten Paritätscodes hinzugefügt sind, von einer Übertragungsleitung und zur Zufuhr der Informationsdaten zu der ersten und zweiten Dekodiereinrichtung (240, 250) ohne Veränderung der Reihenfolge der Informationsdaten.

11. Vorrichtung nach Anspruch 9 oder 10, **dadurch gekennzeichnet, daß**
die Informationsdaten Videodaten sind und die Informationsdaten jedes ersten Codeworts Videoinformationen einer horizontalen Abtastzeile entsprechen.

12. Vorrichtung nach einem der Ansprüche 9 bis 11, **dadurch gekennzeichnet, daß**
die ersten Paritätscodes innere Codeworte und die zweiten Paritätscodes äußere Codeworte sind.

13. Vorrichtung nach einem der Ansprüche 9 bis 12, **dadurch gekennzeichnet, daß**
die zweite Dekodiereinrichtung (240) einen Multiplizierer (211) zur Multiplikation der Informationsdaten und der zweiten Paritätscodes, die das zweite Codewort bilden, durch eine Prüfmatrix (212) und einen Akkumulator (213, 214) enthält, der das Ausgangssignal des Multiplizierers (211) akkumuliert und eine Verzögerungsschaltung (214) mit einer Verzögerungszeit, die länger als eine Periode ist, die N der ersten Codeworte entspricht, und einen Addierer (213) enthält, und die zweite Dekodiereinrichtung (240) einen Fehler unter Verwendung eines aus dem Akkumulator (213, 214) ausgegebenen Syndroms korrigiert.

14. Verfahren zur Dekodierung von Fehlerkorrekturcodes mit den Schritten
Eingeben von Informationsdaten, die mit erste und zweite Paritätscodes aufweisenden Fehlerkorrekturcodes kodiert sind,
Dekodieren einer Vielzahl von ersten Codeworten, die jeweils aus ersten Paritätscodes und einer vorbestimmten Anzahl von aufeinanderfolgenden Informationsdaten bestehen, und
Dekodieren einer Vielzahl von zweiten Codeworten, die jeweils aus zweiten Paritätscodes und Informationsdaten jedes ersten Codeworts einer vorbestimmten Anzahl der ersten Codeworte bestehen,
**dadurch gekennzeichnet, daß**
die vorbestimmte Anzahl der ersten Codeworte jedes N-te erste Codewort ist, wobei N eine ganze Zahl größer oder gleich 2 ist.

15. Verfahren nach Anspruch 14, **dadurch gekennzeichnet, daß**
die Informationsdaten Videodaten sind und die Informationsdaten jedes ersten Codeworts Videoinformationen einer horizontalen Abtastzeile entsprechen.

16. Verfahren nach Anspruch 14 oder 15, **dadurch gekennzeichnet, daß**
die ersten Paritätscodes innere Codeworte und die zweiten Paritätscodes äußere Codeworte sind.

## Revendications

1. Dispositif pour coder des données d'information avec des codes à correction d'erreurs, le dispositif comprenant:
un moyen d'entrée (100) pour entrer une séquence de données d'information;
un premier moyen de codage (150) pour générer une pluralité de premiers mots de code dont chacun est composé de premiers codes de parité et d'un nombre prédéterminé de données d'information consécutives de ladite séquence de données d'information; et
un second moyen de codage (140) pour générer une pluralité de seconds mots de code dont chacun est composé de seconds codes de parité et de données d'information de chacun d'un nombre prédéterminé des premiers mots de code;
caractérisé en ce que
ledit second moyen de codage (140) est conçu pour générer les seconds mots de code de manière que ledit nombre prédéterminé des premiers mots de code soit chaque Nième premier mot de code, N étant un entier égal ou supérieur à 2.

2. Dispositif selon la revendication 1, comprenant de plus un moyen de transmission pour transmettre ladite séquence de données d'information additionnée desdits premiers et seconds codes de parité vers un chemin de transmission, sans changer l'ordre desdites données d'information de ladite séquence de données d'information.

3. Dispositif selon la revendication 1 ou 2, dans lequel lesdites données d'information sont des données vidéo et le nombre prédéterminé de données d'information de chacun des premiers mots de code correspond à l'information vidéo d'une ligne de balayage horizontal.

4. Dispositif selon l'une quelconque des revendications précédentes, dans lequel lesdits premiers codes de parité sont des mots de code interne et lesdits seconds codes de parité sont des mots de code externe.

5. Dispositif selon l'une quelconque des revendications précédentes, dans lequel ledit second moyen de codage (140) comporte un multiplicateur (111) pour la multiplication des données d'information des seconds mots de code et un accumulateur (113, 114) qui accumule les sorties du multiplicateur (111) et comporte un circuit à retard (114) ayant un temps de propagation plus long qu'une période correspondant à N des premiers mots de code et un additionneur (113).

6. Procédé pour coder des données d'information avec des codes à correction d'erreurs, le procédé comprenant les étapes consistant à :
entrer une séquence de données d'information ayant des données d'information consécutives,
générer une pluralité de premiers mots de code dont chacun est composé de premiers codes de parité et d'un nombre prédéterminé des données d'information entrées consécutivement les unes aux autres, et
générer une pluralité de seconds mots de code dont chacun est composé de seconds codes de parité et de données d'information de chacun d'un nombre prédéterminé des premiers mots de code;
caractérisé en ce que
le nombre prédéterminé des premiers mots de code est chaque Nième premier mot de code; N étant un entier égal ou supérieur à 2.

7. Procédé selon la revendication 6, dans lequel lesdites données d'information sont des données vidéo et le nombre prédéterminé de données d'information de chacun des premiers mots de code correspond à l'information vidéo d'une ligne de balayage horizontal.

8. Procédé selon la revendication 6 ou la revendication 7, dans lequel lesdits premiers codes de parité sont des mots de code interne et lesdits seconds codes de parité sont des mots de code externe.

9. Dispositif pour décoder des codes à correction d'erreurs, le dispositif comprenant :
un moyen d'entrée (200) pour entrer des données d'information codées avec des codes à correction d'erreurs comprenant des premiers et seconds codes de parité;
un premier moyen de décodage (250) pour décoder une pluralité de premiers mots de code dont chacun est composé de premiers codes de parité et d'un nombre prédéterminé de données d'information consécutives;
un second moyen de décodage (240) pour décoder une pluralité de seconds mots de code dont chacun est composé de seconds codes de parité et de données d'information de chacun d'un nombre prédéterminé des premiers mots de code;
caractérisé en ce que
ledit second moyen de décodage (240) est conçu pour décoder chacun des seconds mots de code pour effectuer une correction d'erreurs sur les données d'information de chaque Nième premier mot de code, N étant un entier égal ou supérieur à 2.

10. Dispositif selon la revendication 9, comprenant de plus un moyen de réception pour recevoir lesdites données d'information additionnées desdits premiers et seconds codes de parité à partir d'une ligne de transmission et pour fournir lesdites données d'information auxdits premier et second moyens de décodage (240, 250) sans changer l'ordre desdites données d'information.

11. Dispositif selon la revendication 9 ou 10, dans lequel lesdites données d'information sont des données vidéo, et les données d'information de chacun des premiers mots de code correspondent à l'information vidéo d'une ligne de balayage horizontal.

12. Dispositif selon l'une quelconque des revendications 9 à 11, dans lequel les premiers codes de parité sont des mots de code interne et les seconds codes de parité sont des mots de code externe.

13. Dispositif selon l'une quelconque des revendications 9 à 12, dans lequel ledit second moyen de décodage (240) comporte un multiplicateur (211) pour multiplier lesdites données d'information et lesdits seconds codes de parité constituant ledit second mot de code par une matrice de contrôle (212), et un accumulateur (213,214) qui accumule la sortie du multiplicateur (211) et comporte un circuit à retard (214) ayant un temps de propagation plus long qu'une période correspondant à N des premiers mots de code et un additionneur (213), et ledit second moyen de décodage (240) corrige une erreur en utilisant un syndrome délivré en sortie par ledit accumulateur (213, 214).

14. Procédé pour décoder des codes à correction d'erreurs, le procédé comprenant les étapes consistant à :
entrer des données d'information codées avec des codes à correction d'erreurs comprenant des premiers et seconds codes de parité;
décoder une pluralité de premiers mots de code dont chacun est composé de premiers codes de parité et d'un nombre prédéterminé de données d'information consécutives; et
décoder une pluralité de seconds mots de code dont chacun est composé de seconds codes de parité et de données d'information de chacun d'un nombre prédéterminé des premier mots de code;
caractérisé en ce que
le nombre prédéterminé des premiers mots de code est chaque Nième premier mot de code, N étant un entier égal ou supérieur à 2.

15. Procédé selon la revendication 14, dans lequel lesdites données d'information sont des données vidéo et les données d'information de chacun des premiers mots de code correspondent à l'information vidéo d'une ligne de balayage horizontal.

16. Procédé selon la revendication 14 ou 15, dans lequel lesdits premiers codes de parité sont des mots de code interne et lesdits seconds codes de parité sont des mots de code externe.
